# EUROPÄISCHE PATENTANMELDUNG

(11) **EP 1 473 529 A1**
(43) Veröffentlichungstag der Anmeldung: **03.11.2004**
(21) Anmeldenummer: 03009962.6
(22) Anmeldetag: 30.04.2003
(51) Int. Cl.: F25D 29/00, H03K 17/94

(54) **Sensoreinheit sowie Kühlgerät mit einer Sensoreinheit**

(71) Anmelder: Liebherr-Hausgeräte Ochsenhausen GmbH, 88416 Ochsenhausen (DE)
(72) Erfinder: Gerner, Herbert, D-88416 Erlenmoos (DE)
(74) Vertreter: Laufhütte, Dieter, Dr.-Ing.

(57) **Zusammenfassung**

Die vorliegende Erfindung betrifft eine Sensoreinheit zur Detektion des Schließzustandes einer mittels einer Türdichtung abdichtbaren Tür oder Klappe, insbesondere der Tür oder Klappe eines Kühlgerätes mit einem Betätigungselement sowie mit einer Erfassungseinheit (30,40), die in Abhängigkeit der Position des Betätigungselementes unterschiedliche Schalt- oder Signalzustände generiert. Eine Sensoreinheit, die ohne zusätzliches Betätigungselement auskommt und mittels derer auch geringe Türöffnungen erfassbar sind, wird dadurch bereitgestellt, dass das Betätigungselement durch die Türdichtung selbst gebildet wird.

## Beschreibung

Die vorliegende Erfindung betrifft eine Sensoreinheit zur Detektion des Schließzustandes einer mittels einer Türdichtung abdichtbaren Tür oder Klappe, insbesondere der Tür oder Klappe eines Kühlgerätes, mit einem Betätigungselement sowie mit einer Erfassungseinheit, die in Abhängigkeit der Position des Betätigungselementes unterschiedliche Schalt- oder Signalzustände generiert.

Die vorliegende Erfindung betrifft ferner ein Kühlgerät mit Sensoreinheit.

Sensoreinheiten der eingangs genannten Art sind beispielsweise als mechanische Schalter bekannt, die über einen an der Tür befindlichen Schaltnocken betätigt werden bzw. selbst einen verhältnismäßig großen Schaltnocken mit langem Betätigungsweg aufweisen. Bekannt sind derartige Sensoreinheiten beispielsweise bei Kühlschränken. Hier dienen Sie als Lichtschalter und/oder Türtonwarner, die das Licht bei Öffnung des Kühlschrankes einschalten und bei Schließen der Tür wieder ausschalten bzw. dazu dienen, den Bediener des Gerätes durch ein Tonsignal darauf aufmerksam zu machen, dass die Tür nicht vollständig geschlossen ist.

Weiterhin sind Lösungen bekannt, welche einen Reedschalter als Erfassungseinheit sowie einen an der Tür befestigten Magneten als Betätigungselement aufweisen. Unter Einfluß des an der Tür befestigten Magneten wird der Reedschalter, der auf den geänderten magnetischen Fluß reagiert, betätigt und generiert je nachdem, ob die Tür offen oder geschlossen ist, unterschiedliche Schaltzustände.

Derartigen vorbekannten Sensoreinheiten ist es nachteilig, dass stets ein zusätzliches Betätigungselement erforderlich ist, aufgrund dessen unterschiedliche Schalt- bzw. Signalzustände in der Erfassungseinheit hervorgerufen werden. Ein weiterer Nachteil besteht darin, dass sehr geringe Türöffnungen in der Größenordnung von 2 bis 3 mm mit vorbekannten Sensoreinheiten aufgrund der Gerätetoleranzen nicht zuverlässig detektierbar sind. Dies führt dazu, dass beispielsweise im Falle eines Kühlschrankes das Licht und der Türtonwarner ausgeschaltet sind, obwohl die Tür nicht vollständig geschlossen ist. Dies führt zu einem erhöhten Energieverbrauch und insbesondere bei Gefriergeräten zur unerwünschter Vereisung.

Es ist daher die Aufgabe der vorliegenden Erfindung, eine Sensoreinheit zur Verfügung zu stellen, die ohne zusätzliche Betätigungselemente auskommt und durch die auch geringe Türöffnungen erfassbar sind.

Diese Aufgabe wird durch eine Sensoreinheit mit den Merkmalen des Patentanspruchs 1 sowie durch ein Kühlgerät gemäß Patentanspruch 9 gelöst.

Erfindungsgemäß wird bei der Sensoreinheit das Betätigungselement durch die Türdichtung selbst bzw. einen Bestandteil der Türdichtung, z. B. den in einer Magnettürdichtung integrierten Magnetstreifen gebildet. Die Türdichtung dient dazu, ein zuverlässiges Schließen der Tür zu gewährleisten und ist ohnehin am Gerät vorhanden. Es sind daher keine zusätzlichen Betätigungselemente erforderlich, um unterschiedliche Signalzustände der Erfassungseinheit zu generieren.

Besonders vorteilhaft ist es, wenn die Türdichtung als Magnettürdichtung ausgeführt ist. Durch den in einer derartigen Türdichtung integrierten Magnetstreifen wird eine gleichmäßige Betätigungskraft bzw. eine definierte plane Auflage der Dichtung auf die Erfassungseinheit gewährleistet. Eine Betätigung der Erfassungseinheit erfolgt erst dann, wenn die Magnettürdichtung an der entsprechenden Schließkante anliegt.

Die Erfassungseinheit kann als mechanischer Schalter mit einem Schaltnocken ausgeführt sein, der durch die Türdichtung betätigt wird.

Der Schalter kann als im Korpus des Kühlgerätes integrierbarer Mikroschalter ausgeführt sein.

Besonders vorteilhaft ist es, wenn die Erfassungseinheit einen optischen Emitter aufweist und der von diesem ausgesendete Lichtstrahl durch die Position der Türdichtung beeinflussbar ist.

In bevorzugter Ausgestaltung der vorliegenden Erfindung weist die Erfassungseinheit einen optischen Empfänger auf, der derart angeordnet ist, dass der von dem optischen Emitter ausgesendete und von der Türdichtung, vorzugsweise einer Magnettürdichtung reflektierte Lichtstrahl in wenigstens einer Position der Tür oder Klappe, vorzugsweise in der Schließstellung von dem optischen Empfänger erfasst wird. Befindet sich bei einer derartigen Ausführungsform die Tür oder Klappe nicht in der Schließstellung, wird der von dem optischen Emitter ausgesendete Lichtstrahl nicht mehr oder derart an der Türdichtung reflektiert, dass er nicht auf den optischen Empfänger auftrifft. In den genannten Fällen wird zuverlässig der Zustand erfaßt, dass die Tür oder Klappe nicht geschlossen ist, so dass beispielsweise ein entsprechender Warnton abgegeben werden kann und das Licht im Kühlgerät angeschaltet bleibt. In dieser Ausgestaltung der Erfindung wird der an der Türdichtung reflektierte Lichtstrahl genau auf den optischen Empfänger geführt, wenn sich die Tür oder Klappe in der Schließstellung befindet, so dass der Schließzustand eindeutig erfasst wird und beispielsweise das Licht oder der Warnton eines Kühlgerätes abgeschaltet werden.

Beispielsweise kann eine umlaufend an der Tür oder Klappe eines Kühlgerätes angeordnete Türdichtung, beispielsweise eine Magnettürdichtung vorgesehen sein, die im geschlossenen Zustand der Tür bzw. Klappe an der beispielsweise aus Stahl bestehenden Schließkante des Korpus des Kühlgerätes anliegt. Der Lichtstrahl wird von dem optischen Emitter auf die Türdichtung und von dieser vorzugsweise in der Schließstellung zu dem optischen Empfänger geführt.

Der Lichtstrahl tritt vorzugsweise aus der Oberfläche der Schließkante aus, auf der in der geschlossenen Position der Tür oder Klappe die Türdichtung aufliegt.

Liegt die Türdichtung vollständig an der Schließkante an, wird wie oben ausgeführt das von dem optischen Emitter ausgehende Licht beispielsweise derart an der Türdichtung bzw. einem Bestandteil der Türdichtung, z.B. an einem in einer Magnettürdichtung befindlichen Magnetstreifen reflektiert, dass der reflektierte Lichtstrahl exakt auf den optischen Empfänger fällt. Dieser eindeutig detektierbare Signalzustand wird erfasst, sodass in diesem Zustand beispielsweise das Licht des Kühlschrankes sowie der Türtonwarner ausgeschaltet wird. Wird ausgehend von dieser Position die Tür oder Klappe geöffnet, bewegt sich die Türdichtung entsprechend von der Schließkante weg, sodass der reflektierte Lichtstrahl nicht mehr auf den optischen Empfänger auftrifft. Dieser zweite eindeutig definierte Signalzustand kennzeichnet den Offenzustand der Tür oder Klappe. In diesem ist das Licht des Kühlschrankes eingeschaltet und es wird beispielsweise nach Ablauf eines bestimmten Zeitraumes der Türtonwarner aktiviert, um dem Benutzer anzuzeigen, dass die Tür nicht geschlossen ist.

Grundsätzlich ist ebenso eine Ausgestaltung der Erfindung möglich, bei der der von dem optischen Emitter ausgesendete und von der Türdichtung reflektierte Lichtstrahl in der Schließstellung der Tür oder Klappe nicht von dem optischem Empfänger erfasst wird, d.h. nicht auf den optischen Empfänger gerichtet wird. Eine Erfassung des reflektierten Lichtstrahls durch den optischen Empfänger erfolgt in diesem Fall nur in der Offenposition und vorzugsweise bei kleinen Öffnungswinkeln der Tür oder Klappe. Die korrekte Schließposition wird in diesem Fall dadurch signalisiert, dass der optische Empfänger kein auf diesen fallenden Lichtstrahl detektiert.

Durch die erfindungsgemäße Anordnung läßt sich erreichen, das selbst geringe Öffnungen der Tür oder Klappe detektierbar sind, da eine geringe Türöffnung eine Abweichung der Richtung des reflektierten Lichtstrahles erzeugt, die unmittelbar und sofort erfasst werden kann.

Die Erfassungseinheit kann als Schnittstelle ausgeführt sein, mittels derer Betriebsdaten des Gerätes übertragbar sind. Beispielsweise kann durch die den optischen Emitter und Empfänger umfassende Sensoreinheit bzw. die dadurch gebildete Schnittstelle auch auf die Daten der Gerätesteuerung zugegriffen werden. Denkbar ist hier die Nutzung als Serviceschnittstelle bzw. als Kommunikationsschnittstelle zu einer für den Benutzer zugänglichen Bedieneinheit. Der Benutzer kann beispielsweise in der Bedieneinheit Daten eines Kühlgerätes abrufen oder eingeben. Diese Daten werden mittels der genannten Schnittstelle von bzw. zu der Bedieneinheit übertragen.

Beispielsweise kann an der Tür eine Bedieneinheit vorgesehen sein, mittels derer Daten des Gerätes bzw. der Gerätesteuerung eingebbar und/oder abrufbar sind. Die durch die Erfassungseinheit gebildete Schnittstelle kann als Serviceschnittstelle genutzt werden.

Eine Sensoreinheit mit optisch arbeitenden Komponenten bietet entgegen üblichen Schalteranordnungen den Vorteil, dass keine Lebensdauerprobleme durch ständige Betätigung zu erwarten sind, die ansonsten bei Einsatz als Türkontakt gegeben sind. Die Sensoreinheit beinhaltet in dieser Ausführungsform keinerlei mechanische Kontakte und ist darüber hinaus unempfindlich gegen Korrosionseinflüsse. Die Sensoreinheit ist über einen weiten Temperaturbereich einsetzbar und ist aufgrund des Fehlens einer Funkenbildung problemlos auch in Verbindung mit brennbaren Kältemitteln einsetzbar.

In einer weiteren Ausgestaltung der vorliegenden Erfindung umfasst die Erfassungseinheit sowohl mechanisch als auch optisch arbeitende Komponenten, nämlich einen optischen Emitter, einen optischen Empfänger sowie einen durch die Türdichtung bewegbaren Schaltnocken. Dabei ist der optische Empfänger derart angeordnet ist, das der von dem optischen Emitter ausgesendete und von dem Schaltnocken in wenigstens einer Position des Schaltnockens reflektierte Lichtstrahl oder der den Schaltnocken in wenigstens einer Position des Schaltnockens passierende Lichtstrahl von dem optischen Empfänger erfasst wird. Der Schaltnokken wird beim Schließen einer Tür oder Klappe durch die als Betätigungselement dienende Türdichtung eingeführt und beim Öffnen der Tür oder Klappe vorzugsweise mittels einer Feder wieder ausgeschoben. In Abhängigkeit der Position des Schaltnockens trifft der Lichtstrahl auf den optischen Empfänger auf, so dass sich je nach Position der den Schaltnocken bewegenden Türdichtung eindeutige Signalzustände ergeben.

Mittels der erfindungsgemäßen Sensoreinheit sind auch geringe Türöffnungen zuverlässig detektierbar, sodass das oben beschriebene Problem der Vereisung insbesondere von Gefriergeräten sowie der bei offenstehender Tür erhöhte Energieverbrauch zuverlässig vermieden werden können.

In besonders bevorzugter Ausgestaltung der Erfindung ist die Türdichtung als Magnettürdichtung ausgeführt.

Die vorliegende Erfindung betrifft ferner ein Kühlgerät, insbesondere einen Kühlschrank, eine Kühl-Gefrierkombination, einen Gefrierschrank oder eine Gefriertruhe, das dadurch gekennzeichnet ist, dass das Kühlgerät eine Sensoreinheit nach einem der Ansprüche 1 bis 8 aufweist.

In weiterer Ausgestaltung der vorliegenden Erfindung ist vorgesehen, dass die Türdichtung an der Tür oder Klappe des Kühlgerätes angeordnet ist und dass der Korpus des Kühlgerätes eine vorzugsweise Stahl aufweisende Schließkante aufweist, die die Erfassungseinheit ganz oder teilweise umfasst und an der die Türdichtung im Schließzustand der Tür dichtend anliegt.

Weiterhin kann vorgesehen sein, dass die Sensoreinheit gemäß Anspruch 6 ausgeführt ist und dass in der Tür oder Klappe des Kühlgerätes eine Bedieneinheit vorgesehen ist, mittels derer Betriebsdaten des Gerätes abrufbar und/oder eingebbar sind.

In bevorzugter Ausgestaltung der Erfindung ist vorgesehen, dass die Erfassungseinheit sowie die Türdichtung derart angeordnet sind, dass die Position des an der Türdichtung reflektierten Lichtstrahles von dem Öffnungswinkel der Tür oder Klappe des Kühlgerätes abhängt. Auf diese Weise läßt sich sicherstellen, dass der Öffnungswinkel der Tür und somit auch die gewünschte Schließposition mit der Position des reflektierten Lichtstrahles korreliert, so dass eindeutig erkennbar ist, ob die Tür oder Klappe in der Schließposition oder in einer Offenposition steht. Auf diese Weise sind auch kleine Öffnungswinkel der Tür oder Klappe erfassbar und bei Bedarf dem Bediener anzeigbar.

Bei ebenfalls von der vorliegenden Erfindung umfassten Sensoreinrichtungen, bei denen sich der emittierte Lichtstrahl und der an der Türdichtung reflektierte Lichtstrahl im Wesentlichen parallel zu der durch die Türöffnung gebildeten Ebene und die reflektierende Fläche dazu senkrecht erstrecken, ist eine entsprechende Korrelation nicht zu erreichen, da die Position des reflektierten Lichtstrahls von dem Öffnungswinkel der Tür unabhängig ist. Bei einer derartigen Anordnung, bei der eine reflektierende Fläche beispielsweise im Bereich der Oberseite der Tür angeordnet ist, besteht zudem ein Problem darin, dass Veränderungen im Abstand der reflektierenden Fläche der Türdichtung von der Erfassungseinheit zu Fehlermeldungen führen können, da bei sich z. B. vergrößerndem Abstand das reflektierte Signal nicht mehr zuverlässig auf den optischen Empfänger abgebildet wird.

Besonders vorteilhaft ist es, wenn die Türdichtung eine reflektierende Fläche aufweist, die sich in der Schließstellung im Wesentlichen parallel zu der durch die Türöffnung gebildeten Ebene erstreckt.

Die Türdichtung kann in Ihrem gesamten Umfang oder nur in Teilbereichen, beispielsweise ausschließlich in dem Bereich, in dem sie sich in der geschlossenen Position der Tür oder Klappe im Bereich der Erfassungseinheit befindet, reflektierend ausgeführt sein.

In besonders vorteilhafter Ausgestaltung der vorliegenden Erfindung ist die Türdichtung als Magnettürdichtung ausgeführt. Durch den in der Türdichtung integrierten Magnetstreifen lässt sich erreichen, dass eine gleichmäßige Betätigungskraft und eine definierte Plane Auflage der Dichtung auf die Erfassungseinheit gewährleistet ist.

Weitere Einzelheiten und Vorteile der vorliegenden Erfindung werden anhand eines in der Zeichnung dargestellten und im Folgenden beschriebenen Ausführungsbeispiels näher erläutert.

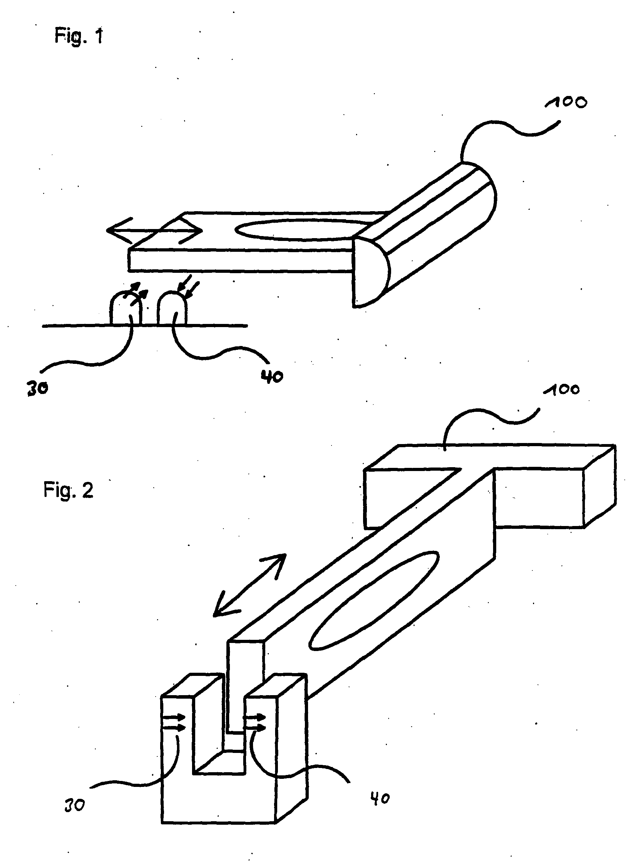

Es zeigen: Fig. 1, Fig. 2: eine schematische Darstellung einer Sensoreinheit mit einem optischen Emitter, einem optischen Empfänger und einem durch ein Betätigungselement bewegbaren Schaltnocken in unterschiedlichen Ausführungsformen.

Fig. 1 zeigt in einer schematischen Darstellung den optischen Emitter 30, den optischen Empfänger 40 sowie einen Schaltnocken 100, der durch die nicht dargestellte Magnettürdichtung betätigt werden kann. Die Bewegungsrichtung des Schaltnokkens 100 ist in Fig. 1 durch den Doppelpfeil dargestellt. In einer ersten, dargestellten Position des Schaltnockens 100 wird das von dem Emitter 30 ausgehende Licht an der Unterseite des Schaltnockens 100 reflektiert und fällt auf den Empfänger 40, wodurch ein erster Schaltzustand eindeutig definiert wird. Wird der Schaltnocken 100 aus der in Fig. 1 dargestellten Position aufgrund der Betätigung durch die Magnettürdichtung derart wegbewegt, daß die Reflexion am Schaltnokken 100 unterbleibt, wird der Lichteinfall am Empfänger 40 unterbunden, wodurch ein zweiter Schaltzustand definiert wird.

Fig. 2 zeigt in einer schematischen Darstellung die Ausführung der Sensoreinheit als Lichtschranke. Hier dient der Schaltnocken 100 dazu, das von dem Emitter 30 ausgehende Licht, das in der in Fig. 2 dargestellten Position des Schaltnockens auf den Empfänger 40 fällt, zu unterbrechen, was dadurch erfolgt, daß der Schaltnokken aufgrund der Betätigung durch die Magnettürdichtung zwischen Emitter 30 und Empfänger 40 verschoben wird. Auch durch diese Ausführungsform lassen sich zwei eindeutig definierte Schaltzustände generieren, so daß entsprechende Signale erzeugbar sind, die die Offen- bzw. Schließposition der Tür oder Klappe eindeutig definieren.

Die Betätigung des Schaltnockens 100 erfolgt durch die an der Tür des Kühlgerätes angeordnetes Magnettürdichtung. Dabei tritt die Magnettürdichtung bei Unterschreiten eines bestimmten Öffnungswinkels mit dem Schaltnocken in Kontakt und schiebt diesen vorzugsweise gegen die Kraft einer Feder ein.

Weitere Ausgestaltungen der vorliegenden Erfindung werden im Folgenden beschrieben:

In der Schließkante des Kühlgerätegehäuses ist nach einer weiteren Ausführungsform der Erfindung ein Schaltelement mit Schaltnocken aufgenommen, das je nach Schaltzustand unterschiedliche Signalzustände abgibt. Die Erzeugung der Schaltzustände kann wie oben erläutert mit optisch arbeitenden Komponenten oder auch durch Öffnen und Schließen mechanischer Kontakte erfolgen. Befindet sich der Schaltnocken in der ausgeschobenen Position, wird die Beleuchtung im Kühlgerät eingeschaltet und es wird nach Ablauf einer bestimmten Zeitspanne ein akustisches oder optisches Warnsignal abgegeben, das dem Bediener anzeigt, dass die Tür oder Klappe offensteht.

Die Betätigung des Schaltnockens erfolgt erfindungsgemäß durch die Magnettürdichtung des Kühlgerätes, die umlaufend an der zum Gehäuse gewandten Innenseite der Tür oder Klappe des Gerätes angeordnet ist. Diese liegt im geschlossenen Zustand der Tür oder Klappe an der Stahl aufweisenden Schließkante des Gehäuses an. In dieser Position der Magnettürdichtung hat diese den Schaltnocken soweit eingeschoben, dass der Schaltzustand "Tür geschlossen" erzeugt wird. Ist dies noch nicht der Fall und steht die Tür oder Klappe eventuell unbemerkt einen Spalt offen, ist der Schaltnocken durch die Magnettürdichtung entweder noch nicht oder um einen Betrag eingeschoben, der noch nicht zur Erzeugung des genannten Schaltzustandes _{"}Tür geschlossen" ausreicht. Dieser Schaltzustand wird erst in der Position des Schaltnockens erzeugt, in dem die Tür oder Klappe vollständig geschlossen ist. Auf diese Weise lässt sich wirksam verhindern, dass der die geschlossene Tür oder Klappe anzeigende Schaltzustand generiert wird, so lange die Magnettürdichtung noch nicht anliegt, wie dies bei vorbekannten Ausführungsformen der Fall sein kann, bei denen ein beliebiges Bauteil, nicht jedoch die Magnettürdichtung als Betätigungselement verwendet wird.

In einer weiteren Ausgestaltung der vorliegenden Erfindung ist vorgesehen, dass die in der Schließkante des Kühlgerätegehäuses aufgenommene Erfassungseinheit aus einem optischen Emitter, beispielsweise einer LED, und einem optischen Empfänger besteht. In diesem Fall erfolgt die Detektion des Offen- oder Schließzustandes der Tür oder Klappe mittels des an der Magnettürdichtung reflektierten Lichtstrahls. Eine Reflexion kann an dem Magnetstreifen, oder an sonstigen reflektierenden Bestandteilen der Magnettürdichtung erfolgen.

Der optische Emitter ist vorzugsweise derart angeordnet, dass der von diesem ausgehende Lichtstrahl aus dem Bereich der Schließkante austritt, auf dem im geschlossenen Zustand der Tür oder Klappe die Magnettürdichtung aufliegt. Dabei steht der emittierte Lichtstrahl auf der durch die Türöffnung gebildeten Ebene senkrecht oder bildet mit der auf dieser Ebene stehenden Senkrechten einen spitzen Winkel.

Liegt die Magnettürdichtung vollständig an der Schließkante an, wird das von dem optischen Emitter ausgesendet Licht derart an der Magnettürdichtung reflektiert, dass der reflektierte Lichtstrahl auf den optischen Empfänger fällt, der daraufhin einen vorgegebenen Schaltzustand _{"}Tür geschlossen" generiert. Alternativ ist eine Ausführungsform der Erfindung möglich, bei der im geschlossenen Zustand der Tür oder Klappe der reflektierte Lichtstrahl nicht auf den optischen Empfänger fällt und dies beispielsweise nur bei geringen Öffnungswinkeln der Fall ist. Bei dieser Ausgestaltung der Erfindung wird der Zustand _{"}Tür geschlossen" generiert, wenn der optische Empfänger kein Lichtsignal empfängt.

Ein Vorteil der Ausführungsform der Erfassungseinheit mit optischen Komponenten ist es, dass keine bewegten Teile vorgesehen sind, was die Lebensdauer entsprechend erhöht. Aufgrund des Fehlens mechanischer Kontakte ist die Erfassungseinheit unempfindlich gegen Korrosionseinflüsse. Die Erfassungseinheit ist über einen weiten Temperaturbereich einsetzbar. Wie oben ausgeführt, ist es aufgrund des Fehlens einer Funkenbildung problemlos möglich, die Erfassungseinheit in Verbindung mit brennbaren Kältemitteln einzusetzen.

Grundsätzlich ist es auch möglich, die Türdichtung bzw. die Magnettürdichtung an dem Kühlgerätegehäuse und die Erfassungseinheit an der Tür oder Klappe des Kühlgerätes anzuordnen.

Hinsichtlich der Anordnung der Erfassungseinheit am Kühlgerät bestehen keine Beschränkungen. Es können ferner eine oder auch mehrere Erfassungseinheiten vorgesehen sein. Prinzipiell ausreichend ist eine derartige Einheit, die beispielsweise an der der Scharnierseite gegenüberliegenden Seite der Tür oder Klappe oder des Gehäuses angeordnet sein kann.

## Patentansprüche

1. Sensoreinheit zur Detektion des Schließzustandes einer mittels einer Türdichtung abdichtbaren Tür oder Klappe, insbesondere der Tür oder Klappe eines Kühlgerätes, mit einem Betätigungselement sowie mit einer Erfassungseinheit, die in Abhängigkeit der Position des Betätigungselementes unterschiedliche Schalt- oder Signalzustände generiert,
**dadurch gekennzeichnet,**
**dass** das Betätigungselement durch die Türdichtung gebildet wird.

2. Sensoreinheit nach Anspruch 1, **dadurch gekennzeichnet, dass** die Erfassungseinheit als mechanischer Schalter mit einem Schaltnocken ausgeführt ist, der durch die Türdichtung betätigt wird.

3. Sensoreinheit nach Anspruch 2, **dadurch gekennzeichnet, dass** der Schalter als im Korpus des Kühlgerätes integrierbarer Mikroschalter ausgeführt ist.

4. Sensoreinheit nach einem der Ansprüche 1 bis 3, **dadurch gekennzeichnet, dass** die Erfassungseinheit einen optischen Emitter aufweist und der von diesem ausgesendete Lichtstrahl durch die Position der Türdichtung beeinflussbar ist.

5. Sensoreinheit nach Anspruch 4, **dadurch gekennzeichnet, dass** die Erfassungseinheit einen optischen Empfänger aufweist, der derart angeordnet ist, dass der von dem optischen Emitter ausgesendete und von der Türdichtung reflektierte Lichtstrahl in wenigstens einer Position der Tür oder Klappe, vorzugsweise in der Schließstellung von dem optischen Empfänger erfasst wird.

6. Sensoreinheit nach Anspruch 4 oder 5, **dadurch gekennzeichnet, dass** die Erfassungseinheit als Schnittstelle ausgeführt ist, mittels derer Betriebsdaten des Kühlgerätes übertragbar sind.

7. Sensoreinheit nach einem der Ansprüche 1 bis 6, **dadurch gekennzeichnet, dass** die Erfassungseinheit einen optischen Emitter (30), einen optischen Empfänger (40) sowie einen durch die Türdichtung bewegbaren Schaltnocken (100) aufweist, wobei der optische Empfänger (40) derart angeordnet ist, das der von dem optischen Emitter (30) ausgesendete und von dem Schaltnocken (100) in wenigstens einer Position des Schaltnockens (100) reflektierte Lichtstrahl oder der den Schaltnocken (100) in wenigstens einer Position des Schaltnockens (100) passierende Lichtstrahl von dem optischen Empfänger (40) erfasst wird.

8. Sensoreinheit nach einem der Ansprüche 1 bis 7, **dadurch gekennzeichnet, dass** die Türdichtung als Magnettürdichtung ausgeführt ist.

9. Kühlgerät, insbesondere Kühlschrank, Kühl-Gefrierkombination, Gefrierschrank oder Gefriertruhe, **dadurch gekennzeichnet, dass** das Kühlgerät eine Sensoreinheit nach einem der Ansprüche 1 bis 8 aufweist.

10. Kühlgerät nach Anspruch 9, **dadurch gekennzeichnet, dass** die Türdichtung an der Tür oder Klappe des Kühlgerätes angeordnet ist und dass der Korpus des Kühlgerätes eine Stahl aufweisende Schließkante aufweist, die die Erfassungseinheit ganz oder teilweise umfaßt.

11. Kühlgerät nach Anspruch 9 oder 10, **dadurch gekennzeichnet, dass** die Sensoreinheit gemäß Anspruch 6 ausgeführt ist und dass in der Tür oder Klappe des Kühlgerätes eine Bedieneinheit vorgesehen ist, mittels derer Betriebsdaten des Gerätes abrufbar und/oder eingebbar sind.

12. Kühlgerät nach einem der Ansprüche 9 bis 11, **dadurch gekennzeichnet, dass** die Sensoreinheit gemäß den Ansprüchen 4 und 5 ausgeführt ist und dass die Erfassungseinheit sowie die Türdichtung derart angeordnet sind, dass die Position des an der Türdichtung reflektierten Lichtstrahls von dem Öffnungswinkel der Tür oder Klappe abhängt.

13. Kühlgerät nach einem der Ansprüche 9 bis 12, **dadurch gekennzeichnet, dass** die Türdichtung eine reflektierende Fläche aufweist, die sich in der Schließstellung der Tür oder Klappe im Wesentlichen parallel zu der durch die Türöffnung gebildeten Ebene erstreckt.
